# EUROPÄISCHE PATENTSCHRIFT

(11) **EP 1 468 042 B1**
(45) Veröffentlichungstag und Bekanntmachung des Hinweises auf die Patenterteilung: **18.04.2007**
(21) Anmeldenummer: 03731660.1
(22) Anmeldetag: 23.01.2003
(51) Int. Cl.: C08J 9/00, C09J 5/08

(54) **MATERIAL ZUR HERSTELLUNG VON FUNKTIONSELEMENTEN MIT MINDESTENS EINEM AUFSCHÄUMBAREN BEREICH SOWIE VERWENDUNG DER FUNKTIONSELEMENTE ZUR POSITIONIERUNG UND MONTAGE VON OBJEKTEN**
MATERIAL FOR THE PRODUCTION OF FUNCTIONAL ELEMENTS COMPRISING AT LEAST ONE FOAMABLE AREA AND USE OF SAID FUNCTIONAL ELEMENTS FOR POSITIONING AND MOUNTING OBJECTS
MATERIAU POUR REALISER DES ELEMENTS FONCTIONNELS COMPORTANT AU MOINS UNE ZONE APTE AU GONFLEMENT, ET UTILISATION DES ELEMENTS FONCTIONNELS POUR POSITIONNER ET FIXER DES OBJETS

(30) Priorität: 24.01.2002 DE 10203455
(43) Veröffentlichungstag der Anmeldung: 20.10.2004
(73) Patentinhaber: JENOPTIK Automatisierungstechnik GmbH, 07745 Jena (DE)
(72) Erfinder: FEISTEL, Ulf, 07646 Laasdorf (DE); DIENER, Roland, 07570 Weida (DE); WEINZIERL, Uwe, 07743 Jena (DE)
(74) Vertreter: Bertram, Helmut
(86) Internationale Anmeldenummer: PCT/DE2003/000197
(87) Internationale Veröffentlichungsnummer: WO 2003/062311

(56) Entgegenhaltungen:
- EP-A- 0 764 706
- PATENT ABSTRACTS OF JAPAN Bd. 0162, Nr. 65 (C-0951), 16. Juni 1992 (1992-06-16) & JP 4 063885 A (ALPHA TECHNO CO LTD), 28. Februar 1992 (1992-02-28)

## Beschreibung

In vielen technischen Bereichen ist es notwendig, die unterschiedlichsten Objekte, wie z. B. optische und elektrische Leiter, auf einfache Weise in bestimmte Positionen zu bringen und gegebenenfalls formangepasst oder in anderer Weise an schwer zugänglichen Orten oder unter anderen schwierigen Bedingungen zu montieren.

Ein derartiges Erfordernis besteht beispielsweise bei flexiblen Folienleitern, die in zunehmendem Maße die traditionellen Leiterplatten und Kupferleiter verdrängen. Folienleiter zeichnen sich sowohl durch ihr geringes Gewicht und Volumen, ihre Flexibilität, als auch durch ihre mechanische und thermische Belastbarkeit aus und können in einer flachen Bandstruktur eine Vielzahl voneinander getrennter, parallel in eine Richtung verlaufender Leiterbahnen zur Verbindung von elektrischen Kontaktstellen enthalten.

Da die bisher in Fahrzeugen vorwiegend eingesetzten Kabelbäume aufgrund einer ständig zunehmenden Zahl von elektrischen Verbrauchern zu immer größer werdenden Platz- und Gewichtsproblemen führen, geht man bei der Leistungsübertragung auch hier zur Folienleitertechnik über. So wurde bereits erkannt, dass dadurch Gewichtsreduzierungen um bis zu 40 Prozent erreicht werden können und eine Verringerung des benötigten Platzes sowie der Anzahl an Verbindungselementen sogar um bis zu 70 Prozent möglich ist.

Bei Fahrzeugen ist es bekannt, in der Armaturentafel unterzubringende Folienleiter in den Spritzprozess einzubeziehen und mit einem geeigneten Schaum zu hinterspritzen oder in einen solchen einzubetten. Sollen die Folienleiter aber von dem vorderen bis in den hinteren Fahrzeugbereich verlegt werden, was üblicherweise über den Dach- oder Bodenbereich zu erfolgen hat, kommt es aufgrund der biegeschlaffen Materialstruktur der Leiterfolien häufig zu Schwierigkeiten bei der Handhabung und bei der Montage. Ein erhöhter Zeitaufwand ist die Folge.

Diese Schwierigkeiten werden auch nicht vermieden, wenn man die Leiterbahnen gemäß der DE 199 39 014 A1 auf eine Seite einer flexiblen Folie aufbringt und die andere Seite der Folie mit der Oberfläche eines bereits vorhandenen Bauteils des Fahrzeugs verbindet.

Auch bei der Signal- und Datenübertragung werden konventionelle Kupferleitungen vermehrt durch Alternativen ersetzt. Der Einsatz von Kunststofflichtwellenleitern wirkt sich z. B. positiv auf die Erhöhung der EMV-Sicherheit aus, wodurch die optische Übertragungstechnik zunehmend breitere Anwendungsgebiete finden wird.

Neben Montageaufgaben bestehen auch Positionieraufgaben, so z. B. bei polymeroptischen Fasern, wenn diese zur Lichtübertragung vorgesehen sind, indem zur Gewährleistung der Übertragungsfunktion eine Ausrichtung der Fasern gegenüber anderen optischen Bauteilen erforderlich ist.

Aufgabe der Erfindung ist es, Positionier- und Montagemöglichkeiten mit verbesserten Handhabungseigenschaften auch an schwer zugänglichen Orten oder unter anderen schwierigen Bedingungen zu schaffen.

Die Lösung der Aufgabe erfolgt durch Funktionselemente mit mindestens einem durch Energiezufuhr aufschäumbaren Bereich, indem mindestens einer der Bereiche als Stellelement zur Positionierung eines Objektes oder zur Elementversteifung genutzt wird.

Die Stellelemente werden durch eine ortsselektive und zeitlich gesteuerte Energiezufuhr, insbesondere von Strahlungsenergie, zu mindestens einem der aufschäumbaren Bereiche erzeugt, wobei durch Volumenänderung eine Verdrängung eines benachbarten Objektes erfolgt.

Die stabilitätserhöhenden Eigenschaften mittels Energiezufuhr aufgeschäumter und anschließend ausgehärteter Bereiche werden für formstabilisierende Versteifungen von flexiblen bzw. biegeschlaffen Materialien und insbesondere für Montageelemente ausgenutzt.

Ein erfindungsgemäßes Material zur Herstellung von Funktionselementen mit mindestens einem aufschäumbaren Bereich besteht aus einer thermoplastischen Matrix, darin enthaltenen Treibmitteln und strahlungsabsorbierenden Einlagerungen, deren Konzentration in einen Bereich gelegt ist, bei der eine Strahlungsabsorption einer zum Aufschäumen dienenden NIR-Strahlung gleichmäßig über die gesamte Dicke des Materials verteilt ist.

Vorteilhafterweise betragen die Konzentrationen der strahlungsabsorbierenden Einlagerungen 0,005 Masse % bis 0,1 Masse % und die Materialdicken 0,5 mm bis 5 mm.

Aufgrund der sehr geringen Konzentration der strahlungsabsorbierenden Einlagerungen wird erreicht, dass eine Absorption der Strahlungsenergie nicht nur in einer oberflächennahen Schicht der thermoplastischen Kunststoffmatrix stattfindet, sondern so weit in die Tiefe vordringt, dass die gesamte Dicke der Kunststoffmatrix umfasst ist.

Die strahlungsabsorbierenden Einlagerungen bewirken zweierlei Effekte. Einerseits wird die Kunststoffmatrix erwärmt. Oberhalb der Glasübergangstemperatur bei amorphen Kunststoffen oder oberhalb des Kristallitschmelzpunktes bei semikristallinen Kunststoffen sinken z.B. die Festigkeit und Viskosität dieser Werkstoffe sehr stark ab, sie gehen in einen thermoplastisch verformbaren Zustand über. In diesem Zustand sind die Materialien durch äußere oder innere Krafteinwirkung leicht verformbar. Z.B. können Kunststoffe in diesem Zustand durch in ihrem Inneren freiwerdende Gase aufgeschäumt werden.
Der zweite Effekt ist die Erwärmung der Treibmittel über eine für jedes dieser Mittel spezifische Temperatur hinaus. Oberhalb dieser Temperatur zerfallen diese Mittel sehr schnell unter Freisetzung von Gasen. Diese freiwerdenden Gase erzeugen dann die Kräfte, die in der erwärmten thermoplastisch verformbaren Kunststoffmatrix zur Schaumbildung und zu deren Expansion führen.

Für die strahlungsabsorbierenden Einlagerungen zur Umwandlung ortsselektiv eingebrachter Strahlungsenergie in Wärme eignen sich gleichartige Farbstoffe oder Pigmente oder eine Mischung aus verschiedenen Farbstoffen oder Pigmenten bzw. eine Mischung von Farbstoffen und Pigmenten, welche in Ihrem Absorptionsverhalten auf den Wellenlängenbereich der zum Aufschäumen verwendeten Strahlung abgestimmt sind. Bedeutsam dabei ist, dass im vorbestimmten Volumenelement des aufzuschäumenden Bereiches eine möglichst gleichmäßige Absorption der Strahlungsenergie erfolgt, um eine gleichmäßige Umwandlung in Wärme zu gewährleisten, die wiederum Voraussetzung für eine homogene Schaumbildung ist. Außerdem soll die Strahlungsenergie nahezu vollständig in Wärme umgewandelt werden.

Vorteilhaft kommen die strahlungsabsorbierenden Einlagerungen aus dem Bereich der anorganischen Blau-Braun- oder Schwarzpigmente. Beispiele hierfür sind Ultramarinblau (Na₈[Al₆Si₆O₂₄]) S₂₋₄, Eisenoxidbraun (Fe₂O₃), Eisenoxidschwarz (Fe₃O₄), Indiumzinnoxid, Graphit oder Ruß. Als organische Pigmente eignen sich hierfür z.B. Phtalocyaninpigmente. Verwendbare Farbstoffe entstammen den Derivaten der Perylencarbonsäure oder auch löslichen Phtalocyaninen. Darüber hinaus können auch konjugierte Polymere, die starke Absorptionen im NIR-Bereich aufweisen, in ihrer jeweils oxidierten oder reduzierten Form eingesetzt werden. Hierzu gehören z.B. Polyanilin oder Poly(3,4-ethylenedioxythiophen).

Das thermoplastische Matrixmaterial kann aus solchen Thermoplasten bestehen, die eine gleichmäßige Verteilung der darin enthaltenen Komponenten zulassen, wie z.B. ABS, PC und PMMA sowie Massenkunststoffe wie LD-PE, HD-PE, PP, PS und EVA (Verwendung der Kunststoffabkürzungen nach ISO 1043-1).

Bei der Erfindung kommen als Treibmittel bevorzugt chemische Treibmittel zur Anwendung, die unter Umgebungsbedingungen sehr stabil sind und bei erhöhter Temperatur unter eigenem Zerfall sehr schnell große Gasmengen abgeben. Die Starttemperatur für die zum Aufschäumen erforderliche Gasfreisetzung ist auf die Eigenschaften des Matrixmaterials abgestimmt. Insbesondere ist die Zersetzungstemperatur der Treibmittel in Hinsicht auf die Erweichungstemperatur des Matrixmaterials spezifiziert. D.h. das Treibmittel soll erst bei einer Temperatur, die eine thermoplastische Verformung des Matrixmaterials zulässt, die größte Menge an Gas freisetzen.
Die Kombination der Treibmittel mit dem Matrixmaterial erfolgt unter den in der kunststoffverarbeitenden Industrie üblichen Vorgehensweisen.
Einzusetzende Treibmittel können aus den Gruppen der Hydrogencarbonate (NaHCO₃), der Ammoniumsalze (NH₄)HCO₃, (NH₄)₂CO₃, (NH₄)NH₂CO₂), der Harnstoffderivate, der Diazoverbindungen (Azodicarbamid), der Semicarbazide (Paratoluolsulfonylsemicarbazid), der Tetrazole (5-Phenyltetrazol) oder anderer stark stickstoffhaltiger Heterozyklen (N.N-Dinitrosopentamethylentetramin) stammen.

Zur Herstellung gut schäumender Materialien werden der Kunststoffmatrix bevorzugt 2 Masse% bis 20 Masse% Treibmittel zugesetzt.

Schließlich können in dem Material zur Herstellung der Funktionselemente weitere Additive, Zusätze und Modifikatoren enthalten sein, soweit diese die beschriebene Energieumwandlung und das Aufschäumen des thermoplastischen Matrixmaterials nicht behindern. Dazu gehören u. a. weitere Farbmittel, die die Absorption der Laserstrahlung nicht behindern, Antioxidantien, UV-Stabilisatoren, Wärmestabilisatoren, Antistatika und Weichmacher. Des Weiteren können auch Additive enthalten sein, die die Schaumbildung unterstützen wie z.B. Keimbildner und Schaumstabilisatoren.

Zur Bereitstellung der Strahlungsenergie für das Aufschäumen kommen bevorzugt Laser zum Einsatz, da diese insbesondere ein ortsselektives Einbringen der Strahlungsenergie in ein vorbestimmtes Volumenelement gewährleisten. Besonders bevorzugt sind wiederum Diodenlaser, da sie aufgrund ihres Strahlprofils besonders geeignet sind, die Lichtenergie gleichmäßig über den ganzen Querschnitt des aufzuschäumenden Volumenelementes einzubringen. Die zur Anwendung vorgesehenen Diodenlaser emittieren vor allem im Wellenlängenbereich des nahes Infrarot (NIR) von ca. 0,8 µm - 2,5 µm.

Der Lösung der Aufgabe dient auch ein Verfahren zur Positionierung eines Objektes mit einer Positioniereinrichtung, bestehend aus einem Träger, der mindestens in einem Teilbereich aufschäumbares Material enthält, mit dem das zu positionierende Objekt in körperlichem Kontakt steht und bei dem durch ortsselektives Aufschäumen des Materials die Positionierung des Objektes durch die Volumenausdehnung erfolgt.

Vorteilhafterweise erfolgt das Aufschäumen mittels zeitlich gesteuerter, ortsselektiv eingebrachter Strahlungsenergie im nahen Infrarot, wie sie durch Laser, insbesondere Diodenlader bereitgestellt werden kann.

Gegenstand der Erfindung ist ferner eine Positioniereinrichtung, bestehend aus einem Träger, der mindestens in einem Teilbereich aufschäumbares Material enthält, das durch ortsselektives und zeitlich gesteuertes Aufschäumen als Stellmittel für ein zu positionierendes Objekt dient.

Die Positioniereinrichtung kann als Träger einen Hohlzylinder aufweisen, dessen umschlossener Hohlraum zur Aufnahme des zu positionierenden Objektes dient und dessen Mantel mindestens ein zum Zentrum des Hohlzylinders gerichtetes Stellmittel aus aufschäumbarem Material enthält.

Das zu positionierende Objekt kann auch auf dem aufschäumbaren Material aufgebracht sein.

Hierbei lassen sich z. B. gekreuzte Leiterbahnen miteinander in Kontakt bringen, indem die Leiterbahnen als zu positionierende Objekt auf zwei Trägern aufgebracht sind, die mit den sich kreuzenden Leiterbahnen einander zugewandt sind, so dass durch ein ortsselektives Aufschäumen des aufschäumbaren Materials eine Kontaktherstellung bei mindestens einem sich kreuzenden Leitungspaar hervorgerufen wird.

Gemäß der Erfindung wird die Aufgabe ferner gelöst durch ein geformtes Montagebauelement, gefertigt aus flexiblem Bandmaterial, das mit einer die Form stabilisierenden Versteifung aus einem, mittels Energiezufuhr aufgeschäumten und anschließend ausgehärteten Material versehen ist.

Das bestehende Handhabungs- und Montageproblem wird somit durch eine Überführung eines sonst flexiblen Elementes mit Hilfe eines aufschäum- und aushärtbaren Materials in eine geformte und verfestigte Struktur beseitigt. Handelt es sich bei dem Bandmaterial um eine Leiterstruktur mit mindestens einer flexiblen Leiterbahn, erhält man mit Hilfe der Erfindung auf einfache Weise ein fertiges Montagebauelement mit den erforderlichen Kurven und Verwindungen, das problemlos im Montageprozess, wie z. B. der Befestigung im Dachholmen eines Autos, zu handhaben ist. Für die Leiterbahnen vorgesehene elektrisch leitende Folien können auf ein Trägermaterial aufgebracht sein.

Besonders von Vorteil ist es, dass das Bandmaterial auch nach dem Aufbringen des aufschäumbaren Materials seine bereits zuvor vorhandenen flexiblen Eigenschaften behält und in vielfacher Weise be- und verarbeitet werden kann, solange der Aufschäum- und Aushärtprozess noch nicht durchgeführt wurde. So können elektrisch leitende Folien immer wie Folien geformt, geprägt oder strukturiert werden, unabhängig davon, ob das Auftragen des aufschäumbaren Materials bereits erfolgt ist oder noch nicht.

Neben der Anwendung der Erfindung bei flexiblen Folienleitern zur Leitung des elektrischen Stromes können in einer weiteren vorteilhaften Ausgestaltung auch geformte Strukturen von Glasfaserleitern zur Licht- und/oder Informationsübertragung hergestellt werden.

Die obenstehende Aufgabe wird ferner erfindungsgemäß durch ein Verfahren zur Herstellung eines geformten Montagebauelementes aus flexiblem Bandmaterial gelöst, bei dem auf das flexible Bandmaterial ein aufschäumbares Material aufgebracht wird, das nach einer Formung des Bandmaterials mittels Energiezufuhr, die z. B. durch Laserstrahlung erzeugt werden kann, aufgeschäumt und anschließend zu einer die Form stabilisierenden Versteifung ausgehärtet wird.

Zur Formung des Bandmaterials sollte eine dem Ort der Montage nachgebildete Werkzeugform verwendet werden, in der eine Aufnahme des Bandmaterials vorteilhaft durch Ansaugen erfolgt.

Die Erfindung soll nachstehend anhand von Beispielen und anhand der schematischen Zeichnung näher erläutert werden. Es zeigen:
- Fig. 1: einen Ausschnitt aus einer Werkzeugform mit einer geformten flexiblen Leiterbahn
- Fig. 2: ein formbares Trägermaterial mit aufgebrachten Folienleitern
- Fig. 3: eine Seitenansicht einer Positioniereinrichtung für z. B. polymeroptische Fasern (POF)
- Fig. 4: einen Schnitt A-A durch die Positioniereinrichtung gemäß Fig. 3
- Fig. 5: zwei Träger mit aufgebrachten Leiterbahnen
- Fig. 6: die Anordnung der beiden Träger, bei der sich kreuzende Leiterbahnen zur Kontaktherstellung durch Aufschäumen ausgewählter Bereiche gegenüberliegen
- Fig. 7: die Anordnung gemäß Fig. 6, bei der zwei Leiterbahnen miteinander kontaktiert sind
- Fig. 8: einen vergrößerten Ausschnitt der kontaktierten Leiterbahnen

Die Herstellung der erfindungsgemäßen Materialien und die Herstellung von Präformlingen bzw. Halbzeugen, die in einem nachfolgenden Prozess ortsselektiv aufgeschäumt werden, kann durch verschiedene Verfahren erfolgen:
- Sintern pulverförmiger Ausgangsstoffe in beheizten Werkzeugen
- Verarbeitung aus flüssiger Phase (Lösung/Suspension) durch Sprühen, Streichen, Rakeln oder Drucken.
- Compoundierung durch Extrusion

Für den Sinterprozess, der im Wesentlichen nach den Verfahren des Heißprägens von Kunststoffteilen erfolgt, werden die Ausgangsmaterialien in Pulverform eingesetzt. Von Vorteil ist es, Korngrößenfraktionen zu verwenden, die eine ähnliche Korngröße aufweisen, um Entmischungs-/Sedimentationserscheinungen zwischen verschiedenen Korngrößen zu unterbinden. Die gleichmäßige Verteilung der in sehr geringen Mengen einzusetzenden Farbmittel kann z. B. durch Aufpudern oder Verwendung von pulverförmigen Farbmasterbatchen sichergestellt werden. Diese Pulvermischungen werden in beheizbare Werkzeuge eingefüllt, die zur Formgebung die Kontur des erwünschten Halbzeuges/Präformlings als Kavität enthalten. Bei erhöhter Temperatur werden die Pulver zusammengesintert. Der Wert der Temperaturerhöhung ist vom eingesetzten Matrixkunststoff abhängig. Bei amorphen Kunststoffen werden bevorzugt Temperaturen zwischen der Glasübergangstemperatur und einer Temperatur, die 40 K über der Glasübergangstemperatur liegt, eingesetzt. Bei semikristallinen Kunststoffen werden Sintertemperaturen geringfügig unterhalb des Kristallitschmelzpunktes insbesondere Temperaturen von ± 10 K um die Vicat B-Temperatur (DIN ISO 306) bevorzugt. Durch Anlegen eines Druckes bevorzugt im Bereich von 50 bar bis 300 bar fließt das Material unter Vermischung in die Form. Die Formfüllung und die Dichte der Sinterkörper kann durch das Anlegen von Vakuum an die Kavität verbessert werden.

Die Verarbeitung aus flüssiger Phase (Lackherstellung und -verarbeitung) bedingt die Herstellung einer applikationsfähigen Flüssigkeit. Bei dieser kann es sich sowohl um eine Lösung, als auch um eine Suspension handeln. Voraussetzung für die Anwendbarkeit ist, dass alle für das aufschäumbare Material notwendigen Komponenten, d. h. das thermoplastische Matrixmaterial, das Treibmittel und die strahlungsabsorbierenden Einlagerungen enthalten sind. Für die Herstellung einer Suspension können zusätzlich Dispersionsmittel oder Emulgatoren zur Stabilisierung enthalten sein.
Die Materialkomponenten werden in den entsprechenden Anteilen in einem organischen Lösungsmittel oder einem organischen Lösungsmittelgemisch aufgelöst bzw. in einem Lösungsmittel-Wasser-Gemisch suspendiert. Die Viskosität der Flüssigkeiten und das Verdunstungs- und Benetzungsverhalten wird hierbei so eingestellt, dass die Flüssigkeit mit den an sich bekannten Lackverarbeitungstechnologien appliziert werden kann.
Nach der Aufbringung der Flüssigkeit z.B. durch Streichen, Spritzen, Rakeln, Tauchen oder Drucken und der physikalischen Trocknung kann die applizierte Schicht des aufschäumbaren Materials zwischengelagert oder weiterverarbeitet werden.

Bei der Extrusion der Komponenten zu Endloshalbzeugen werden die Komponenten im gewünschten Verhältnis vorher miteinander vermischt und aufgeschmolzen vermischt/homogenisiert und anschließend ausgeformt. Hierbei ist zu beachten, dass die Verarbeitungstemperatur und die einzusetzenden Materialien, d. h. das Matrixmaterial und das Treibmittel so aufeinander abzustimmen sind, dass einerseits das Matrixmaterial aufgeschmolzen und homogenisiert werden kann, andererseits die dazu notwendige Temperatur noch nicht dazu führt, dass sich das Treibmittel unter Gasfreisetzung zersetzt.

### Beispiel 1

20 kg EVA-Granulat werden in einer Fassrollstation mit 1513 g Azodicarbamid und 108 g eines 2 %igen Rußmasterbatches vermischt. Das resultierende Gemisch enthält die Einzelkomponenten in Anteilen von 92,99 %, 7 %, 0,01 % (bezogen auf den Rußanteil).
Das Gemisch wird in einem Extruder unter Verwendung der vom Kunststoffhersteller angegebenen Verarbeitungsparameter für das Kunststoffgranulat aufgeschmolzen und homogenisiert. Mit Hilfe einer Breitschlitzdüse wird das Material zu einer Platte von 2 mm Dicke ausgeformt.
Diese Platte wird einer definierten Laserstrahlung ausgesetzt. Benutzt wird hierzu ein fasergekoppelter Diodenlaser mit einer Wellenlänge von 808 nm und einer maximalen Leistung von 30 W. Mit Hilfe eines Optikkopfes wird die Laserstrahlung auf die aufzuschäumende Kontur fokussiert. Mit Hilfe eines Bewegungssystems (Portal) wird der Laser mit gleichbleibender Geschwindigkeit über das Bauteil bewegt. Die Laseranlage ist in diesem Fall mit einem Pyrometer ausgestattet, das die Temperatur auf der Oberfläche des zu bearbeitenden Materials misst und die Laserleistung entsprechend einer vorgegebenen Temperatur regelt.
Bei einer Temperatur von 180°C und einer Bewegungsgeschwindigkeit von 10 mm/s kann das Material entlang der Bewegungskontur aufgeschäumt werden.

### Beispiel 2

20 kg LD-PE Granulat werden in einer Fassrollstation mit 1081 g Azodicarbamid und 540 g eines 2 %igen Graphitmasterbatches vermischt. Das resultierende Gemisch enthält die Einzelkomponenten in Anteilen von 94,95 %, 5 %, 0,05 % (bezogen auf den Graphitanteil).

Das Gemisch wird in einem Extruder, unter Verwendung der vom Kunststoffhersteller angegebenen Verarbeitungsparameter, für das Kunststoffgranulat aufgeschmolzen und homogenisiert. Mit Hilfe einer Breitschlitzdüse wird das Material zu einer Folie von 0,5 mm Dicke ausgeformt.
Diese Folie wird einer definierten Laserstrahlung ausgesetzt. Benutzt wird hierzu ein freistrahlender Diodenlaser mit einer Wellenlänge von 940 nm und einer maximalen Leistung von 25 W. Bei einer Einwirkzeit des Lasers von 0,4 s und einer Laserleistung von 20 W wird die Geometrie des Freistrahlers (Balken von 20 mm x 1,5 mm) als aufgeschäumter Bereich auf der Folie abgebildet.

### Beispiel 3

85 g eines PP-Pulvers (Siebfraktion 125 µm - 250 µm) werden mit 15 g gemörsertem Azodicarbamid und 0,1 g fein gepulvertem ITO (Indiumzinnoxid) innig vermischt. Das resultierende Gemisch enthält die Einzelkomponenten in Anteilen von 84,9 %, 15 %, 0,1 %. Die Mischung wird anschließend in einem Presswerkzeug bei 150°C und 200 bar zu einer 2 mm starken Platte zusammengesintert.
Bei Behandlung dieser Platte mit einem freistrahlenden Diodenlaser der Wellenlänge 940 nm (2 s, 20 W) bildet sich die Kontur des Freistrahlers als aufgeschäumter Bereich auf der Platte ab.

### Beispiel 4

10 g 5-Phenytetrazol werden in einer Kugelmühle mit 0,1 g Vanadylphtalocyanin vermahlen, wobei darauf zu achten ist, dass die Temperatur nicht über 80 °C ansteigt. Zu dem erhaltenen Pulver werden 90 g PMMA-Pulver zugegeben und vermischt. Das resultierende Gemisch enthält die Einzelkomponenten in Anteilen von 89,9 %, 10 %, 0,1 %. Die Mischung wird anschließend in einem Presswerkzeug bei 130°C und 200 bar zu einer 2 mm starken Platte zusammengesintert.
Bei Behandlung dieser Platte mit einem fasergekoppelten 808 nm Diodenlasersystem (Fokusdurchmesser 0,8 mm, 40 W, 5 mm/s) kann eine aufgeschäumte Struktur auf dem Bauteil erzeugt werden.

### Beispiel 5

In einem Lösungsmittelgemisch bestehend aus 100 ml 2-Propoxyethanol und 900 ml 1,3□ Dioxolan werden unter leichtem Erwärmen (T < 40°C) und ständigem Rühren 90 g PC, 10 g N.N-Dinitrosopentamethylentetramin und 0,005 g Uvinol (Markenname der BASF) aufgelöst. Der Feststoffanteil der Lösung enthält die Einzelkomponenten in Anteilen von 89,995 %, 10 %, 0,005 %.
Der Lack wird durch Rakeln in einer Nassfilmdicke von 200 µm auf eine Unterlage aus Polymidfolie aufgetragen. Nach dem Trocknen des Lacks erfolgt die Laserbehandlung. Es wird mit einem fasergekoppelten Diodenlaser der Wellenlänge 808 nm gearbeitet. Bei einer Bearbeitungsgeschwindigkeit von 5 mm/s und einer Leistung von 30 W erfolgt ein ortsselektives Aufschäumen.

Die als Präformlinge bzw. Halbzeuge vorliegenden Produkte können wegen der aufschäumbaren Bereiche als Funktionselemente in verschiedener Weise ausgebildet, verarbeitet und verwendet werden.

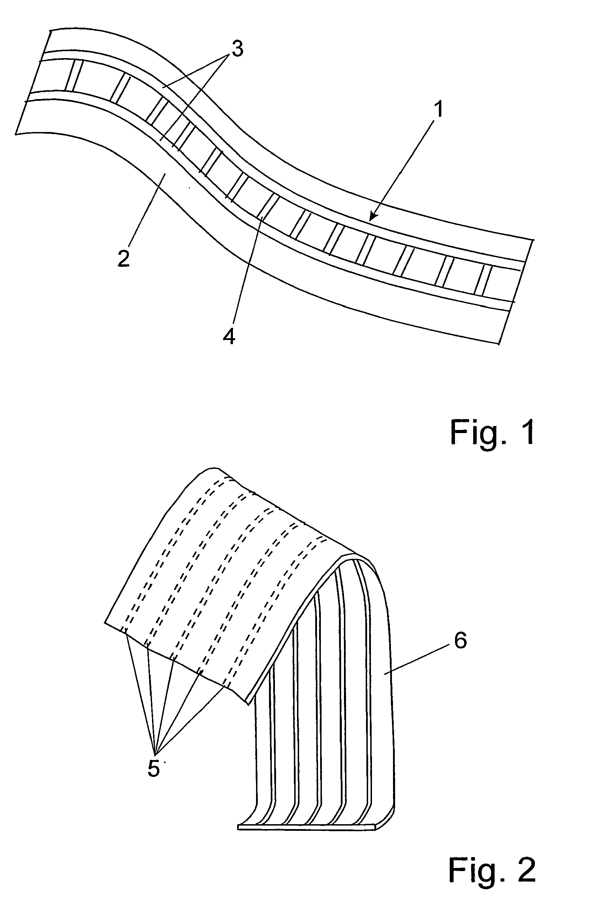

Bei der in Fig. 1 ausschnittsweise dargestellten Werkzeugform liegt eine flexible Leiterbahn 1 auf einer, den Verlegeweg für die Leiterbahn 1 entsprechenden Auflagefläche 2 auf. Bei der vorliegenden Ausführung besteht die Leiterbahn 1 aus einem ausgeprägten Aluminium-oder Kupferfolienleiter, bei dem dünne Streifen 3 durch Abstandshalter 4 voneinander getrennt sind. Die durch die Auflage hervorgerufene Formung der Leiterbahn 1 wird vorzugsweise durch einen Ansaugvorgang erreicht, wofür in der Auflagefläche 2 geeignete, in der Figur aber nicht sichtbare Ansaugstellen vorgesehen sind.

Eine andere Ausführung kann vorsehen, die Leiterbahn 1 durch Andrücken an die Auflagefläche 2 in die beabsichtigte Form zu bringen.

Unabhängig davon, wie die zur Formung dienende Anlage der Leiterbahn 1 in der Werkzeugform hergestellt wird, sind die verwendeten Aluminium- oder Kupferfolienleiter auf einer Seite mit einem aufschäumbaren Material z. B. durch flächiges Aufstreichen, Aufdrucken oder Aufsprühen versehen, das mittels Energiezufuhr, vorzugsweise durch Anwendung von Laserstrahlung aufgeschäumt wird, so dass nach dem Aushärten dieses Materials aus der ursprünglich flexiblen Leiterbahn 1 ein dem Profil der Werkzeugform angepasstes starres Gebilde entsteht.

Die Folienleiter 5 können gemäß Fig. 2 auch auf einem dünnen Träger 6 aufgebracht sein, der selbstverständlich noch so flexibel sein muss, dass er sich der Kontur der Werkzeugform durch Ansaugen oder Andrücken anpassen kann.

Die erfindungsgemäße geformte Struktur ist nicht allein auf elektrische Folienleiter beschränkt. In einer geeignet ausgebildeten Werkzeugform lassen sich auch Glasfaserleiter oder anderes flexibles (biegeschlaffes) Bandmaterial zu einer geformten Struktur, wie einem fertigen Montagebauelement ausbilden.

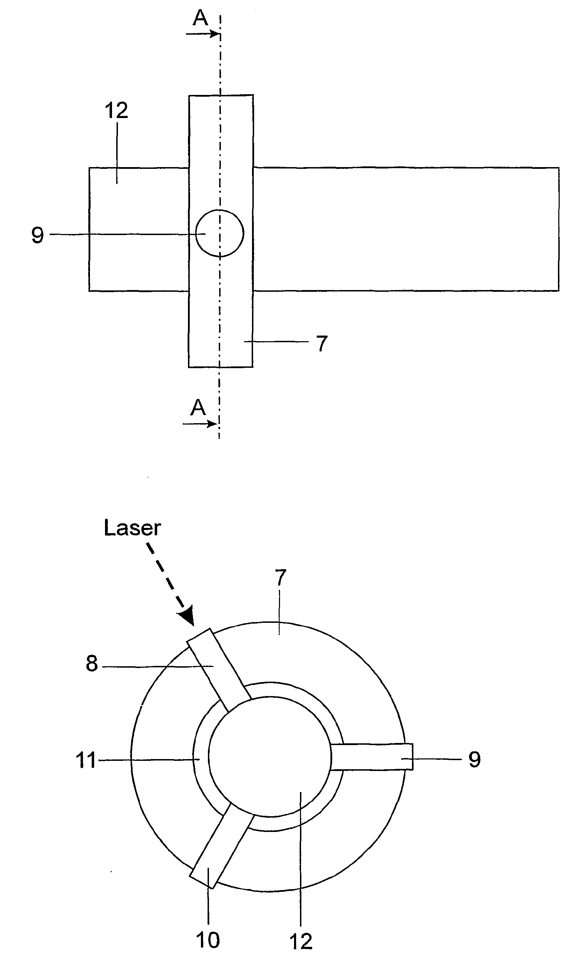

Die in den Figuren 3 und 4 dargestellte Positioniereinrichtung stellt eine weitere Anwendung für Funktionselemente mit aufschäumbaren Bereichen dar.

Ein als Hohlzylinder 7 ausgebildeter Träger enthält in seinem Mantel mehrere, im vorliegenden Ausführungsbeispiel drei zum Zentrum des Hohlzylinders 7 gerichtete Stellmittel 8, 9 und 10 aus aufschäumbarem Material. Der umschlossene Hohlraum 11 dient zur Aufnahme eines zu positionierenden Objektes, wie z. B. einer polymeroptischen Faser 12.

Polymeroptische Fasern werden neben ihrem Einsatz in der Kommunikationstechnik, wo sie in lokalen Netzwerken, ähnlich wie Glasfasern dem Datenaustausch dienen, auch in Beleuchtungssystemen verwendet, insbesondere zur Beleuchtung explosionsgefährdeter Räume oder zur dezentralen Beleuchtung, wie z. B. im Automobil.
Hierbei besteht das Erfordernis, die zur Lichtübertragung dienenden Fasern in Relation zu anderen optischen Bauteilen (z. B. Lichtquelle, Linsen, Diffusor) zu positionieren.

Zu diesem Zweck kann die Positioniereinrichtung gemäß den Figuren 3 und 4 verwendet werden, indem in die Stellmittel 8, 9 und 10 Strahlungsenergie eines Lasers eingekoppelt wird. In Abhängigkeit von der gewünschten Position der Faser 12 wird eines oder mehrere der Stellmittel 8, 9 und 10 mit einer erforderlichen Energiemenge beaufschlagt. In Abhängigkeit von der eingesetzten Energiemenge wird ein Aufschäumen hervorgerufen, wodurch eine entsprechende Volumenzunahme der Stellmittel 8, 9 und 10 und eine radiale Verschiebung der Faser 12 in die gewünschte Richtung resultiert.
Beeinträchtigungen der polymeroptischen Faser 12 durch die für das Aufschäumen benutzte Laserstrahlung treten nicht ein, da zur Lichtübertragung vorgesehene Fasern nicht im benutzten nahen Infrarot absorbieren.

Selbstverständlich beschränkt sich die Anwendung der Positioniereinrichtung nicht ausschließlich auf die Positionierung von optischen Fasern. Die Positioniereinrichtung kann entsprechend auch anderen zu positionierenden Objekten angepasst sein. Wesentlich ist hierbei die Schaffung von Stellelementen durch eine zeitlich unterschiedlich lange Bestrahlung aufschäumbarer Bereiche, durch deren Volumenänderung eine Verdrängung eines benachbarten Objektes hervorgerufen werden kann.

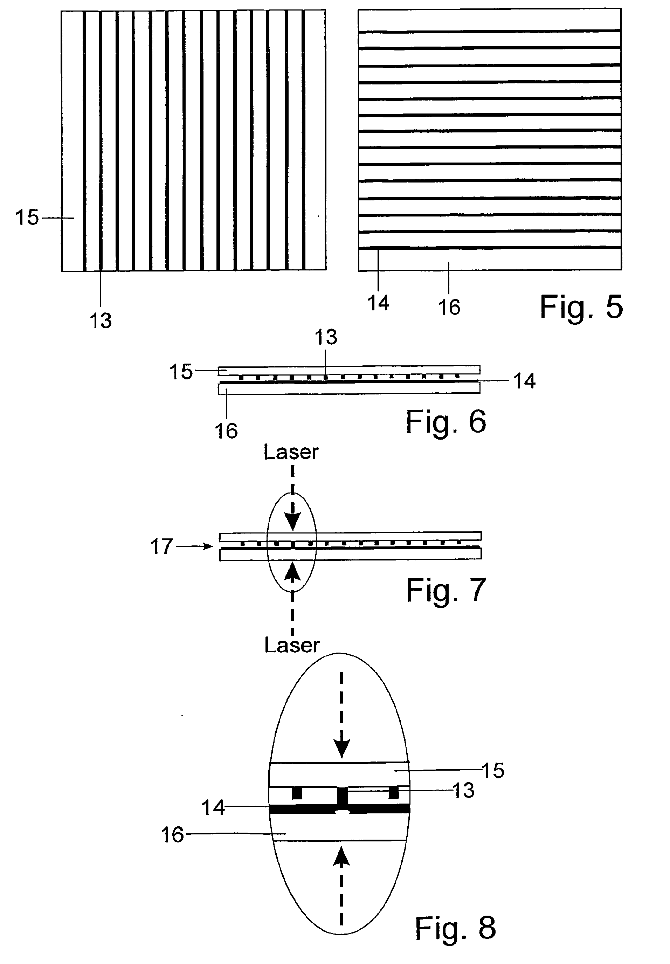

Auch bei einer weiteren Anwendung der mit aufschäumbaren Bereichen versehenen Funktionselemente werden Positionsveränderungen an Objekten vorgenommen. Hierbei handelt es sich gemäß den Figuren 5 bis 8 um Leiterbahnen 13 und 14, die auf aufschäumbarem Material der Träger 15 und 16 aufgebracht sind.
Die Träger 15 und 16 können insbesondere Folien oder dünne Platten aus den laserschäumbaren Materialien sein, die mit Leiterbahnen versehen sind. Zum Aufbringen der Leiterbahnen können bekannte Technologien verwendet werden, solange eine erforderliche Wärmebehandlung nicht zur Initiierung des Aufschäumprozesses führt.
Geeignet sind z. B. das Heißprägen, wie es auch in 3-D MID Prozessen (3-D MID - 3 Dimensional Moulded Interconnected Devices) benutzt wird. Andererseits ist auch das Auflaminieren und Strukturieren von Kupferfolien analog zur Leiterplattentechnik nutzbar.

Die beiden Träger 15 und 16 werden entsprechend Fig. 6 mit den einander zugewandten, sich kreuzenden Leiterbahnen 13 und 14 mit einem gegenseitigen Abstand zueinander positioniert, der geringer ist als die Dicke, um die die beiden Träger 15 und 16 zusammen durch eine Laserbehandlung in Richtung zueinander aufgeschäumt werden können.
Die Herstellung eines Kontaktes bei einem sich kreuzenden Leitungspaar erfolgt schließlich durch ein ortsselektives Aufschäumen der beiden Träger 15 und 16 mit einem geeigneten Laser (Fig. 7 und 8), indem durch die hervorgerufene Materialausdehnung der Spalt 17 geschlossen wird.

## Patentansprüche

1. Material zur Herstellung von Funktionselementen mit mindestens einem aufschäumbaren Bereich, bestehend aus einer thermoplastischen Matrix, darin enthaltenen Treibmitteln und strahlungsabsorbierenden Einlagerungen, deren Konzentration in einen Bereich gelegt ist, bei der eine Strahlungsabsorption einer zum Aufschäumen dienenden NIR-Strahlung gleichmäßig über die gesamte Dicke des Materials verteilt ist.

2. Material nach Anspruch 1, bei dem als strahlungsabsorbierende Einlagerungen anorganische Blau-Braun- oder Schwarzpigmente dienen.

3. Material nach Anspruch 2, bei dem als strahlungsabsorbierende Einlagerungen Ultramarinblau (Na₈[Al₆Si₆O₂₄])S₂₋₄, Eisenoxidbraun (Fe₂O₃), Eisenoxidschwarz (Fe₃O₄), Indiumzinnoxid, Graphit oder Ruß vorgesehen sind.

4. Material nach Anspruch 1, bei dem als strahlungsabsorbierende Einlagerungen organische Pigmente dienen.

5. Material nach Anspruch 4, bei dem als organische Pigmente Phtalocyaninpigmente vorgesehen sind.

6. Material nach Anspruch 1, bei dem als strahlungsabsorbierende Einlagerungen Farbstoffe dienen.

7. Material nach Anspruch 6, bei dem als Farbstoffe Derivate der Perylencarbonsäure vorgesehen sind.

8. Material nach Anspruch 6, bei dem als Farbstoffe lösliche Phtalocyanine vorgesehen sind.

9. Material nach Anspruch 1, bei dem als strahlungsabsorbierende Einlagerungen konjugierte Polymere in ihrer jeweils oxidierten oder reduzierten Form eingesetzt werden, die eine starke Absorption im NIR-Bereich aufweisen.

10. Material nach Anspruch 9, bei dem als konjugierte Polymere Polyanilin oder Poly(3,4-ethylenedioxythiophen) vorgesehen sind.

11. Material nach einem der Ansprüche 1 bis 10, bei dem Materialdicken von 0,5 mm bis 5 mm vorgesehen sind.

12. Material nach einem der Ansprüche 1 bis 11, bei dem die strahlungsabsorbierenden Einlagerungen im Bereich von 0,005 Masse % bis 0,1 Masse % liegen.

13. Material nach einem der Ansprüche 1 bis 12, bei dem die thermoplastische Kunststoffmatrix Treibmittel von 2 Masse% bis 20 Masse% enthält.

14. Material nach einem der Ansprüche 1 bis 13, bei dem weitere Additive, Zusätze und/oder Modifikatoren zugesetzt sind.

15. Material nach einem der Ansprüche 1 bis 14, hergestellt als Sinterwerkstoff durch Kunststoffheißprägen

16. Material nach einem der Ansprüche 1 bis 14, hergestellt als applikationsfähige Flüssigkeit oder Lack in Form einer Lösung oder Suspension.

17. Verwendung von Funktionselementen mit mindestens einem aufschäumbaren Bereich zur Positionierung von Objekten, wobei durch eine ortsselektive und zeitlich gesteuerte Energiezufuhr zu mindestens einem der aufschäumbaren Bereiche Stellelemente erzeugt werden, die durch Volumenänderung zur Verdrängung eines benachbarten Objektes dienen.

18. Verwendung von Funktionselementen mit mindestens einem aufschäumbaren Bereich zur Versteifung von flexiblem oder biegeschlaffem Material.

19. Verwendung von Funktionselementen mit mindestens einem aufschäumbaren Bereich als Montageelemente mit einer die Form stabilisierenden Versteifung aus mindestens einem, mittels Energiezufuhr aufgeschäumten und anschließend ausgehärteten Bereich.

20. Verwendung nach einem der Ansprüche 17 bis 19, bei der die Energiezufuhr mittels Laserstrahlung im nahen Infrarot erfolgt.

21. Verfahren zur Positionierung eines Objektes mit einer Positioniereinrichtung, bestehend aus einem Träger, der mindestens in einem Teilbereich aufschäumbares Material enthält, mit dem das zu positionierende Objekt in körperlichem Kontakt steht und bei dem durch ortsselektives Aufschäumen des Materials die Positionierung des Objektes durch die Volumenausdehnung erfolgt.

22. Verfahren nach Anspruch 21, bei dem das Aufschäumen mittels zeitlich gesteuerter, ortsselektiv eingebrachter Strahlungsenergie erfolgt.

23. Verfahren nach Anspruch 22, bei dem zur Bereitstellung der Strahlungsenergie Laser verwendet werden.

24. Verfahren nach Anspruch 23, bei dem als Laser zur Bereitstellung der Strahlungsenergie Diodenlaser verwendet werden, die in einem Wellenlängenbereich des nahen Infrarot (NIR) emittieren.

25. Positioniereinrichtung, bestehend aus einem Träger, der mindestens in einem Teilbereich aufschäumbares Material enthält, das durch ortsselektives und zeitlich gesteuertes Aufschäumen als Stellmittel für ein zu positionierendes Objekt dient.

26. Positioniereinrichtung nach Anspruch 25, bei der der Träger als Hohlzylinder ausgebildet ist, dessen umschlossener Hohlraum zur Aufnahme des zu positionierenden Objektes dient und dessen Mantel mindestens ein zum Zentrum des Hohlzylinders gerichtetes Stellmittel aus aufschäumbarem Material enthält.

27. Positioniereinrichtung nach Anspruch 25, bei der das zu positionierende Objekt auf dem aufschäumbaren Material aufgebracht ist.

28. Positioniereinrichtung nach Anspruch 27, bei welcher zwei Träger als zu positionierende Objekt Leiterbahnen aufweisen und mit den sich kreuzenden Leiterbahnen einander zugewandt sind, so dass durch ein ortsselektives Aufschäumen des aufschäumbaren Materials eine Kontaktherstellung bei mindestens einem sich kreuzenden Leitungspaar hervorgerufen wird.

29. Geformtes Montagebauelement, gefertigt aus flexiblem Bandmaterial mit einer die Form stabilisierenden Versteifung aus einem, mittels Energiezufuhr aufgeschäumten und anschließend ausgehärteten Material versehen ist.

30. Montagebauelement nach Anspruch 29, **dadurch gekennzeichnet, dass** das Bandmaterial eine Leiterstruktur mit mindestens einer flexiblen Leiterbahn umfasst.

31. Montagebauelement nach Anspruch 30, **dadurch gekennzeichnet, dass** die flexiblen Leiterbahnen elektrisch leitende Folienleiter sind.

32. Montagebauelement nach Anspruch 30, **dadurch gekennzeichnet, dass** die flexiblen Leiterbahnen Glasfaserleiter zur Licht- und/oder Informationsübertragung sind.

33. Verfahren zur Herstellung eines geformten Montagebauelementes aus flexiblem Bandmaterial, **dadurch gekennzeichnet, dass** auf das flexible Bandmaterial ein aufschäumbares Material aufgebracht wird, das nach einer Formung des Bandmaterials mittels Energiezufuhr aufgeschäumt und anschließend zu einer die Form stabilisierenden Versteifung ausgehärtet wird.

34. Verfahren nach Anspruch 33, **dadurch gekennzeichnet, dass** zur Formung des Bandmaterials eine dem Ort der Montage entsprechende Werkzeugform dient.

35. Verfahren nach Anspruch 34, **dadurch gekennzeichnet, dass** zur Energiezufuhr Laserstrahlung verwendet wird.

36. Verfahren nach Anspruch 35, **dadurch gekennzeichnet, dass** eine Aufnahme des Bandmaterials in der Werkzeugform durch Ansaugen erfolgt.

37. Verfahren nach Anspruch 36, **dadurch gekennzeichnet, dass** das Bandmaterial eine Leiterstruktur mit mindestens einer flexiblen Leiterbahn umfasst.

38. Verfahren nach Anspruch 36, **dadurch gekennzeichnet, dass** die flexiblen Leiterbahnen elektrisch leitende Folienleiter sind.

39. Verfahren nach Anspruch 36, **dadurch gekennzeichnet, dass** die flexiblen Leiterbahnen Glasfaserleiter zur Licht- und/oder Informationsübertragung sind.

## Claims

1. Material for producing functional elements that comprise at least one foamable region, said material consisting of a thermoplastic matrix, with foaming agents and radiation-absorbing inclusions contained therein, whose concentration is located in a range in which a radiation absorption of NIR radiation used for foaming is uniformly distributed over the entire thickness of the material.

2. Material according to claim 1, wherein inorganic blue, brown or black pigments serve as radiation-absorbing inclusions.

3. Material according to claim 2, wherein ultramarine blue (Na₈[Al₆Si₆O₂₄])S₂₋₄, brown iron oxide (Fe₂O₃), black iron oxide (Fe₃O₄), indium tin oxide, graphite or soot are provided as radiation-absorbing inclusions.

4. Material according to claim 1, wherein organic pigments serve as radiation-absorbing inclusions.

5. Material according to claim 4, wherein phthalocyanine pigments are provided as the organic pigments.

6. Material according to claim 1, wherein dyes serve as radiation-absorbing inclusions.

7. Material according to claim 6, wherein derivatives of perylene carboxylic acid are provided as the dyes.

8. Material according to claim 6, wherein soluble phthalocyanines are provided as the dyes.

9. Material according to claim 1, wherein conjugated polymers exhibiting strong absorption in the NIR range are employed in their respective oxidized or reduced forms as radiation-absorbing inclusions.

10. Material according to claim 9, wherein polyaniline or poly(3,4-ethylene dioxythiophene) are provided as conjugated polymers.

11. Material according to any one of claims 1 to 10, wherein material thicknesses of from 0.5 mm to 5 mm are provided.

12. Material according to any one of claims 1 to 11, wherein the radiation-absorbing inclusions are present in a range of from 0.005 % by weight to 0.1 % by weight.

13. Material according to any one of claims 1 to 12, wherein the thermoplastic matrix comprises 2 % by weight to 20 % by weight of foaming agents.

14. Material according to any one of claims 1 to 13, wherein further additives, addition agents and/or modifiers are added.

15. Material according to any one of claims 1 to 14, produced as a sintered material by hot stamping of plastic materials.

16. Material according to any one of claims 1 to 14, produced as an applicable liquid or lacquer in the form of a solution or suspension.

17. Use of functional elements comprising at least one foamable region for positioning objects, wherein locally selective and time-controlled supply of energy to at least one of the foamable regions produces adjusting elements which, by a change in volume, serve to displace an adjacent object.

18. Use of functional elements comprising at least one foamable region for reinforcement of flexible or flexibly slack material.

19. Use of functional elements comprising at least one foamable region as mounting elements including a form-stabilising reinforcement which consists of at least one region foamed by supply of energy and subsequently cured.

20. Use according to any one of claims 17 to 19, wherein the energy supply is effected by means of laser radiation in the near infrared range.

21. Method for positioning an object with a positioning device, which device consists of a carrier containing foamable material in at least a partial region thereof, the object to be positioned being in physical contact with said material, and wherein positioning of the object is effected by the volumetric expansion caused by locally selective foaming of the material.

22. Method according to claim 21, wherein foaming is effected by means of time-controlled radiation energy introduced in a locally selective manner.

23. Method according to claim 22, wherein lasers are used to provide the radiation energy.

24. Method according to claim 23, wherein diode lasers emitting in a near-infrared (NIR) wave range are used as lasers to provide the radiation energy.

25. Positioning device consisting of a carrier which contains foamable material in at least a partial region thereof, which material, by locally selective and time-controlled foaming, serves as an adjusting means for an object to be positioned.

26. Positioning device according to claim 25, wherein the carrier is provided as a hollow cylinder whose enclosed void serves to receive the object to be positioned and whose jacket contains at least one adjusting means of foamable material, said adjusting means being directed towards the centre of the hollow cylinder.

27. Positioning device according to claim 25, wherein the object to be positioned is applied onto the foamable material.

28. Positioning device according to claim 27, wherein two carriers comprise, as objects to be positioned, strip conductors and are placed such that the intersecting strip conductors face each other so that locally selective foaming of the foamable material causes a contact to be established between at least one intersecting pair of conductors.

29. Moulded mounting element, made from flexible band material comprising a form-stabilising reinforcement which consists of a material foamed by supply of energy and then cured.

30. Mounting element according to claim 29, **characterised in that** the band material comprises a conductive structure including at least one flexible strip conductor.

31. Mounting element according to claim 30, **characterised in that** the flexible strip conductors are electrically conductive foil conductors.

32. Mounting element according to claim 30, **characterised in that** the flexible strip conductors are optical fibers for transmission of light and/or information.

33. Method of producing a moulded mounting element from a flexible band material, **characterised in that** a foamable material is applied onto the flexible band material, which foamable material is foamed, after moulding the band material, by supply of energy and is subsequently cured to produce a form-stabilising reinforcement.

34. Method according to claim 33, **characterised in that** a tool mould corresponding to the mounting site serves to mould the band material.

35. Method according to claim 34, **characterised in that** laser radiation is used to supply the energy.

36. Method according to claim 35, **characterised in that** reception of the band material within the tool mould is effected by suction.

37. Method according to claim 36, **characterised in that** the band material comprises a conductive structure including at least one flexible strip conductor.

38. Method according to claim 36, **characterised in that** the flexible strip conductors are electrically conductive foil conductors.

39. Method according to claim 36, **characterised in that** the flexible strip conductors are optical fibers for transmission of light and/or information.

## Revendications

1. Matériau destiné à produire des éléments fonctionnels qui comportent au moins une région moussable, ledit matériau se composant d'une matrice thermoplastique, dans laquelle sont contenus des agents moussants et des inclusions absorbant le rayonnement, dont la concentration est placée dans une gamme dans laquelle une absorption de rayonnement par rapport au rayonnement proche infrarouge utilisé pour le moussage soit uniformément répartie sur toute l'épaisseur du matériau.

2. Matériau selon la revendication 1, dans lequel des pigments inorganiques bleus, bruns ou noirs servent comme inclusions qui absorbent le rayonnement.

3. Matériau selon la revendication 2, dans lequel l'outremer bleu (Na₈[Al₆Si₆O₂₄])S₂₋₄, l'oxyde brun de fer (Fe₂O₃), l'oxide noir de fer (Fe₃O₄), l'oxide stannique d'indium, le graphite ou la suie sont prévus comme inclusions qui absorbent le rayonnement.

4. Matériau selon la revendication 1, dans lequel des pigments organiques servent comme inclusions qui absorbent le rayonnement.

5. Matériau selon la revendication 4, dans lequel des pigments de phthalocyanine sont prévus comme pigments organiques.

6. Matériau selon la revendication 1, dans lequel des colorants servent comme inclusions qui absorbent le rayonnement.

7. Matériau selon la revendication 6, dans lequel des dérivés de l'acide carboxylique de pérylène sont prévus comme colorants.

8. Matériau selon la revendication 6, dans lequel des phthalocyanines solubles sont prévus comme colorants.

9. Matériau selon la revendication 1, dans lequel des polymères conjugués sont employés, dans leurs formes respectives oxidée ou réduite, comme inclusions qui absorbent le rayonnement, ces polymères présentant une forte absorption dans la gamme proche infrarouge.

10. Matériau selon la revendication 9, dans lequel le polyaniline ou le poly(3,4-éthylène dioxythiophène) sont prévus comme polymères conjugués.

11. Matériau selon l'une quelconque des revendications 1 à 10, dans lequel des épaisseurs du matériau de 0,5 mm à 5 mm sont prévues.

12. Matériau selon l'une quelconque des revendications 1 à 11, dans lequel les inclusions qui absorbent le rayonnement sont présentes dans une gamme de 0,005 % en poids à 0,1 % en poids.

13. Matériau selon l'une quelconque des revendications 1 à 12, dans lequel la matrice thermoplastique présente de 2 % en poids à 20 % en poids d'agents moussants.

14. Matériau selon l'une quelconque des revendications 1 à 13, dans lequel on ajoute encore des additifs, des produits d'addition et/ou des modificateurs.

15. Matériau selon l'une quelconque des revendications 1 à 14, produit en tel que matériau fritté par estampage à chaud de matières plastiques.

16. Matériau selon l'une quelconque des revendications 1 à 14, produit en tel que liquide ou vernis applicable sous forme d'une solution ou d'une suspension.

17. Utilisation d'éléments fonctionnels comportant au moins une région moussable pour le positionnement d'objets, lors de laquelle un apport d'énergie, effectué d'une manière localement sélective et commandé dans le temps, à au moins une des régions moussables produit des éléments de justage qui servent à déplacer, par changement de volume, un objet adjacent.

18. Utilisation d'éléments fonctionnels comportant au moins une région moussable pour le renforcement d'un matériau flexible ou mou en flexion.

19. Utilisation d'éléments fonctionnels comportant au moins une région moussable comme éléments de montage qui présentent un renforcement stabilisant la forme et se composant d'au moins une région qui est moussée par apport d'énergie et ensuite durcissée.

20. Utilisation selon l'une quelconque des revendications 17 à 19, lors de laquelle l'apport d'énergie s'effectue au moyen d'un rayonnement laser dans le proche infrarouge.

21. Procédé de positionnement d'un objet avec un dispositif de positionnement, ledit dispositif consistant d'un support qui contient du matériau moussable dans au moins une région partielle du support, l'objet à positionner étant en contact physique avec ledit matériau, procédé dans lequel le positionnement dudit objet se fait par expansion volumétrique résultant du moussage localement sélectif du matériau.

22. Procédé selon la revendication 21, dans lequel le moussage s'effectue au moyen d'énergie rayonnante commandé dans le temps et introduit de manière localement sélective.

23. Procédé selon la revendication 22, dans lequel on utilise des lasers afin de fournir l'énergie rayonnante.

24. Procédé selon la revendication 23, dans lequel des lasers à diode émettant dans une gamme d'ondes du proche infrarouge (PIR) sont utilisés comme lasers fournissant l'énergie rayonnante.

25. Dispositif de positionnement constitué d'un support, ledit support contenant un matériau moussable dans au moins une régione partielle de celui-ci, ledit matériau servant, par moussage localement sélectif et commandé dans le temps, comme moyen de justage pour un objet à positionner.

26. Dispositif de positionnement selon la revendication 25, dans lequel ledit support est réalisé sous forme d'un cylindre creux dont le vide enfermé sert à recevoir l'objet à positionner et dont la chemise contient au moins un moyen de justage en matériau moussable, ledit moyen de justage étant dirigé vers le centre du cylindre creux.

27. Dispositif de positionnement selon la revendication 25, dans lequel l'objet à positionner est appliqué sur le matériau moussable.

28. Dispositif de positionnement selon la revendication 27, dans lequel deux supports comportent, comme objets à positionner, des conducteurs à ruban et lesdits supports sont placés de telle manière que leurs conducteurs à ruban se croisant fassent face les uns aux autres de sorte que le moussage localement sélectif du matériau moussable fasse établir un contact entre au moins une paire croisante de conducteurs.

29. Élément moulé de montage, fabriqué d'un matériau en ruban flexible comportant un renforcement qui stabilise la forme et se compose d'un matériau moussé par apport d'énergie et puis durcissé.

30. Élément de montage selon la revendication 29, **caractérisé en ce que** le matériau en ruban comporte une structure conductrice qui présente au moins un conducteur à ruban flexible.

31. Élément de montage selon la revendication 30, **caractérisé en ce que** les conducteurs à ruban flexibles sont des conducteurs en feuille conduisant l'éléctricité.

32. Élément de montage selon la revendication 30, **caractérisé en ce que** les conducteurs à ruban flexibles sont des fibres optiques pour la transmission de lumière et/ou d'informations.

33. Procédé destiné à fabriquer un élément de montage moulé d'un matériau à ruban flexible, ledit procédé étant **caractérisé en ce qu'**un matériau moussable est appliqué sur ledit matériau à ruban flexible, ledit matériau moussable étant moussé, après moulage du matériau à ruban, par apport d'énergie dans celui-ci et est ensuite durcissé afin de donner un renforcement stabilisant la forme.

34. Procédé selon la revendication 33, **caractérisé en ce qu'**un moule d'outil qui correspond à l'endroit de montage sert à mouler le matériau à ruban.

35. Procédé selon la revendication 34, **caractérisé en ce que** du rayonnement laser est utilisé pour l'apport d'énergie.

36. Procédé selon la revendication 35, **caractérisé en ce que** le matériau à ruban est reçu dans le moule d'outil se fait par aspiration.

37. Procédé selon la revendication 36, **caractérisé en ce que** le matériau à ruban comporte une structure conductrice qui présente au moins un conducteur à ruban flexible.

38. Procédé selon la revendication 36, **caractérisé en ce que** les conducteurs à ruban flexible sont des conducteurs en feuille qui conduisent l'électricité.

39. Procédé selon la revendication 36, **caractérisé en ce que** les conducteurs à ruban flexibles sont des fibres optiques pour la transmission de lumière et/ou d'informations.
